# EUROPEAN PATENT APPLICATION

(11) **EP 4 722 429 A1**
(43) Date of publication of application: **08.04.2026**
(21) Application number: 25194616.6
(22) Date of filing: 07.08.2025
(51) Int. Cl.: C30B 29/36

(54) **SIC EPITAXIAL WAFER AND SIC DEVICE**

(30) Priority: 13.08.2024 JP 2024134794
(71) Applicant: Resonac Corporation, Tokyo 105-7325 (JP)
(72) Inventor: WATANABE, Yoshifumi, Tokyo (JP)
(74) Representative: Strehl & Partner mbB

(57) **Abstract**

A SiC epitaxial wafer according to an embodiment includes a SiC substrate, and a SiC epitaxial layer on one surface of the SiC substrate. The SiC epitaxial layer has a buffer layer and a drift layer. The buffer layer is located between the drift layer and the SiC substrate, and has an impurity concentration higher than an impurity concentration of the drift layer. The impurity concentration of the buffer layer is 2.0×10¹⁸ cm⁻³ or more. In a case where the impurity concentration at a center in plan view in a laminating direction is measured in the laminating direction, uniformity of the impurity concentration in the buffer layer is 50% or less.

## Description

### BACKGROUND OF THE INVENTION

### Field of the Invention

The present invention relates to a SiC epitaxial wafer and a SiC device.

Priority is claimed on Japanese Patent Application No. 2024-134794, filed August 13, 2024, the content of which is incorporated herein by reference.

### Description of Related Art

Silicon carbide (SiC) has a dielectric breakdown field that is one order of magnitude larger than that of silicon (Si) and a band gap that is three times larger. Silicon carbide (SiC) also has a property that its thermal conductivity is about three times higher than that of silicon (Si). Therefore, silicon carbide (SiC) is expected to be applied to power devices, high frequency devices, high temperature operating devices, and the like. In recent years, SiC epitaxial wafers have come to be used in such semiconductor devices.

A SiC epitaxial wafer is obtained by laminating a SiC epitaxial layer on a surface of a SiC substrate. Hereinafter, the substrate before the SiC epitaxial layer is laminated thereon is referred to as a SiC substrate, and the substrate after the SiC epitaxial layer is laminated thereon is referred to as a SiC epitaxial wafer. The SiC substrate is cut from a SiC ingot.

In the SiC epitaxial wafer, basal plane dislocation (BPD) is known to be one of device killer defects that cause fatal defects in the SiC device. For example, when a current is passed through a bipolar device in a forward direction, the recombination energy of flowing carriers causes partial dislocations of the basal plane dislocation inherited by the SiC epitaxial layer from the SiC substrate to move and expand, and thus high-resistance lamination defects are formed. A high resistance portion generated in the device causes a decrease in reliability of the device (forward degradation).

Attempts have been made to reduce the basal plane dislocation inherited in the SiC epitaxial layer. For example, Patent Document 1 describes that a proportion of basal plane dislocations inherited by a SiC epitaxial layer can be reduced by growing the SiC epitaxial layer at high speed (for example, at a growth rate of 50 µm/h or more).

Furthermore, for example, Patent Document 2 describes that the occurrence of high-resistance lamination defects can be curbed by co-doping boron, titanium, vanadium, or the like in addition to a main element that serves as an n-dopant.

### [Patent Documents]

[Patent Document 1] Japanese Unexamined Patent Application, First Publication No. 2018-113303
[Patent Document 2] Japanese Unexamined Patent Application, First Publication No. 2019-134046

### SUMMARY OF THE INVENTION

In order to increase a conversion rate of basal plane dislocations to threading edge dislocations (TEDs) in the middle of a buffer layer, it is preferable to increase the growth rate of the SiC epitaxial layer. On the other hand, when the growth rate of the SiC epitaxial layer is increased, the impurity concentration may change in a laminating direction of the SiC epitaxial layer. For example, Patent Document 2 also states that the impurity concentration changes at an interface between the SiC substrate and the SiC epitaxial layer. When the impurity concentration in the buffer layer is less than 2.0×10¹⁸ cm⁻³, a change in the impurity concentration in the laminating direction hardly occurs, and even when the change does occur, it is negligible. In contrast, when the impurity concentration of the buffer layer is increased to 2.0×10¹⁸ cm⁻³ or more and the SiC epitaxial layer is grown at a high rate, the change in the impurity concentration in the laminating direction becomes significant and cannot be ignored. Although the change in the impurity concentration in the laminating direction can be curbed by slowing down the growth rate of the SiC epitaxial layer, the conversion rate of the basal plane dislocations to the threading edge dislocations decreases.

The present disclosure has been made in consideration of the above problems, and has an object to provide a SiC epitaxial wafer in which a change in the impurity concentration of a buffer layer in a laminating direction is small.

In order to solve the above problems, the present disclosure provides the following means.
(1) A SiC epitaxial wafer according to a first aspect includes a SiC substrate, and a SiC epitaxial layer on one surface of the SiC substrate. The SiC epitaxial layer has a buffer layer and a drift layer. The buffer layer is located between the drift layer and the SiC substrate, and has an impurity concentration higher than an impurity concentration of the drift layer. The impurity concentration of the buffer layer is 2.0×10¹⁸ cm⁻³ or more. In a case where the impurity concentration at a center in plan view in a laminating direction is measured in the laminating direction, uniformity of the impurity concentration in the buffer layer is 50% or less. The uniformity of the impurity concentration in the buffer layer is calculated by (Iₘₐₓ-Iₘᵢₙ)/Iₐᵥₑ. Iₘₐₓ is the maximum value of the impurity concentration in the buffer layer in the laminating direction. Iₘᵢₙ is the minimum value of the impurity concentration in the buffer layer in the laminating direction. Iₐᵥₑ is the average value of the impurity concentration in the buffer layer in the laminating direction.
(2) In the SiC epitaxial wafer according to the above-described aspect (1), in a case where the impurity concentration at a first outer periphery point located 5 mm from an outermost periphery in plan view in the laminating direction is measured in the laminating direction, the uniformity of the impurity concentration in the buffer layer may be 50% or less.
(3) In the SiC epitaxial wafer according to the above-described aspect (1) or (2), in a case where the impurity concentration at any point in plan view in the laminating direction is measured in the laminating direction, the uniformity of the impurity concentration in the buffer layer may be 50% or less.
(4) In the SiC epitaxial wafer according to any one of the above-described aspects (1) to (3), in a case where the impurity concentration at the center in plan view in the laminating direction is measured in the laminating direction, in an interface vicinity region within 3 µm toward the buffer layer from an interface between the SiC substrate and the buffer layer, a change range of the impurity concentration may be 50% or less of the average value of the impurity concentration in the buffer layer in the laminating direction.
(5) In the SiC epitaxial wafer according to any one of the above-described aspects (1) to (4), in a case where an impurity concentration at a first outer periphery point located 5 mm from an outermost periphery in plan view in the laminating direction is measured in the laminating direction, in an interface vicinity region within 3 µm toward the buffer layer from an interface between the SiC substrate and the buffer layer, a change range of the impurity concentration may be 50% or less of the average value of the impurity concentration in the buffer layer in the laminating direction.
(6) In the SiC epitaxial wafer according to any one of the above-described aspects (1) to (5), an in-plane uniformity of the impurity concentration in the buffer layer may be 50% or less. The in-plane uniformity of the impurity concentration in the buffer layer may be calculated by |I₁-I₂|/{(I₁+I₂)/2}. I₁ may be the impurity concentration of the buffer layer at the center in plan view in the laminating direction. I₂ may be the impurity concentration of the buffer layer at a first outer periphery point located 5 mm from an outermost periphery in plan view in the laminating direction.
(7) In the SiC epitaxial wafer according to any one of the above-described aspects (1) to (6), an impurity concentration of the drift layer may be 1.0×10¹⁵ cm⁻³ or more and 1.0×10¹⁸ cm⁻³ or less.
(8) In the SiC epitaxial wafer according to any one of the above-described aspects (1) to (7), a conversion rate of basal plane dislocations in the buffer layer may be 99.997% or more.
(9) In the SiC epitaxial wafer according to any one of the above-described aspects (1) to (8), a basal plane dislocation density in the drift layer may be 0.25 dislocations/cm⁻² or less.
(10) In the SiC epitaxial wafer according to any one of the above-described aspects (1) to (9), a basal plane dislocation density in the SiC substrate may be 9000 dislocations/cm⁻² or less.
(11) A diameter of the SiC epitaxial wafer according to any one of the above-described aspects (1) to (10) may be 149 mm or more.
(12) A diameter of the SiC epitaxial wafer according to any one of the above-described aspects (1) to (11) may be 199 mm or more.
(13) A SiC device according to a second aspect includes a SiC substrate, and a SiC epitaxial layer on one surface of the SiC substrate. The SiC epitaxial layer has a buffer layer and a drift layer. The buffer layer is located between the drift layer and the SiC substrate, and has an impurity concentration higher than an impurity concentration of the drift layer. The impurity concentration of the buffer layer is 2.0×10¹⁸ cm⁻³ or more. In a case where the impurity concentration is measured in a laminating direction, uniformity of the impurity concentration in the buffer layer is 50% or less. The uniformity of the impurity concentration in the buffer layer is calculated by (Iₘₐₓ-Iₘᵢₙ)/Iₐᵥₑ. Iₘₐₓ is the maximum value of the impurity concentration in the buffer layer in the laminating direction. Iₘᵢₙ is the minimum value of the impurity concentration in the buffer layer in the laminating direction. Iₐᵥₑ is the average value of the impurity concentration in the buffer layer in the laminating direction.
(14) In the SiC device according to the above-described aspect (13), in a case where the impurity concentration at a center in plan view in the laminating direction is measured in the laminating direction, in an interface vicinity region within 3 µm toward the buffer layer from an interface between the SiC substrate and the buffer layer, a change range of the impurity concentration may be 50% or less of the average value of the impurity concentration in the buffer layer in the laminating direction.
(15) **In** the SiC device according to the above-described aspect (13) or (14), the impurity concentration of the drift layer may be 1.0×10¹⁵ cm⁻³ or more and 1.0×10¹⁸ cm⁻³ or less.
(16) In the SiC device according to any one of the above-described aspects (13) to (15), the conversion rate of basal plane dislocations in the buffer layer may be 99.997% or more.
(17) In the SiC device according to any one of the above-described aspects (13) to (16), the basal plane dislocation density in the drift layer may be 0.25 dislocations/cm⁻² or less.
(18) In the SiC device according to any one of the above-described aspects (13) to (17), the basal plane dislocation density in the SiC substrate may be 9000 dislocations/cm⁻² or less.

In the SiC epitaxial wafer and the SiC device according to the above-described aspect, a change in the impurity concentration of the buffer layer in the laminating direction is small.

### BRIEF DESCRIPTION OF THE DRAWINGS

FIG. 1 is a cross-sectional view of a SiC epitaxial wafer according to a first embodiment.
FIG. 2 is a plan view of the SiC epitaxial wafer according to the first embodiment.
FIG. 3 is a cross-sectional view of an apparatus for manufacturing the SiC epitaxial wafer according to the first embodiment.
FIG. 4 is a schematic diagram showing a method for manufacturing the SiC epitaxial wafer according to the first embodiment.
FIG. 5 is a plan view showing a SiC device according to the first embodiment.

### DETAILED DESCRIPTION OF THE INVENTION

Hereinafter, an embodiment will be described in detail with reference to the drawings as appropriate. The drawings used in the following description may show characteristic parts enlarged for convenience in order to make features of the embodiment easier to understand, and dimensional ratios of each component may differ from actual ones. Materials, dimensions, and the like exemplified in the following description are merely examples, and the present disclosure is not limited thereto and can be implemented with appropriate modifications within the scope that does not change the gist of the disclosure.

First, directions are defined as follows. One direction in a plane in which a SiC substrate extends is defined as an X direction, and a direction perpendicular to the X direction in the same plane is defined as a Y direction. An X direction is, for example, a <11-20> direction, and the Y direction is, for example, a <1-100> direction. A Z direction is a direction perpendicular to the SiC substrate and perpendicular to the X and Y directions. The Z direction coincides with a thickness direction of the SiC substrate and a laminating direction of a SiC epitaxial layer.

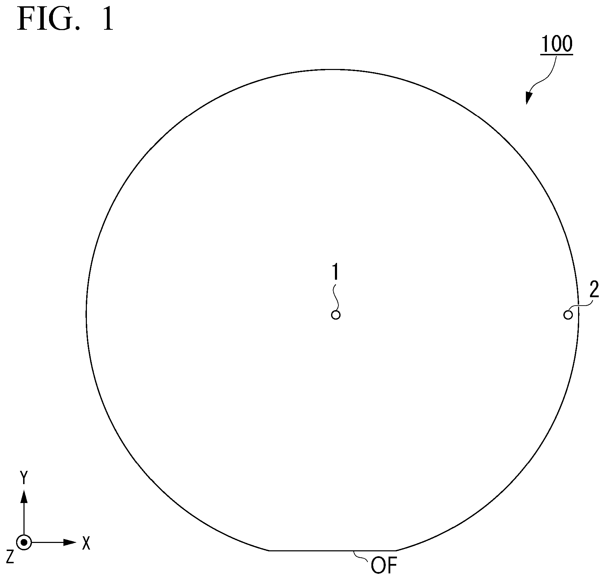

FIG. 1 is a plan view of a SiC epitaxial wafer 100 according to a first embodiment. A shape of the SiC epitaxial wafer 100 in plan view is substantially circular. The SiC epitaxial wafer 100 may have an orientation flat OF or a notch for determining a direction of a crystal axis.

There is no particular limitation on a diameter of the SiC epitaxial wafer 100. The diameter of the SiC epitaxial wafer 100 is, for example, 140 mm or more, and may be 149 mm or more. The diameter of the SiC epitaxial wafer 100 may be, for example, 149 mm or more and 151 mm or less. The diameter of the SiC epitaxial wafer 100 may be, for example, 190 mm or more, or 199 mm or more. The diameter of the SiC epitaxial wafer 100 may be, for example, 199 mm or more and 201 mm or less. The diameter of the SiC epitaxial wafer 100 may be, for example, 240 mm or more, or 249 mm or more. The diameter of the SiC epitaxial wafer 100 may be, for example, 249 mm or more and 251 mm or less. The diameter of the SiC epitaxial wafer 100 may be, for example, 290 mm or more, or 299 mm or more. The diameter of the SiC epitaxial wafer 100 is, for example, 301 mm or less. The diameter of the SiC epitaxial wafer 100 may be, for example, 299 mm or more and 301 mm or less.

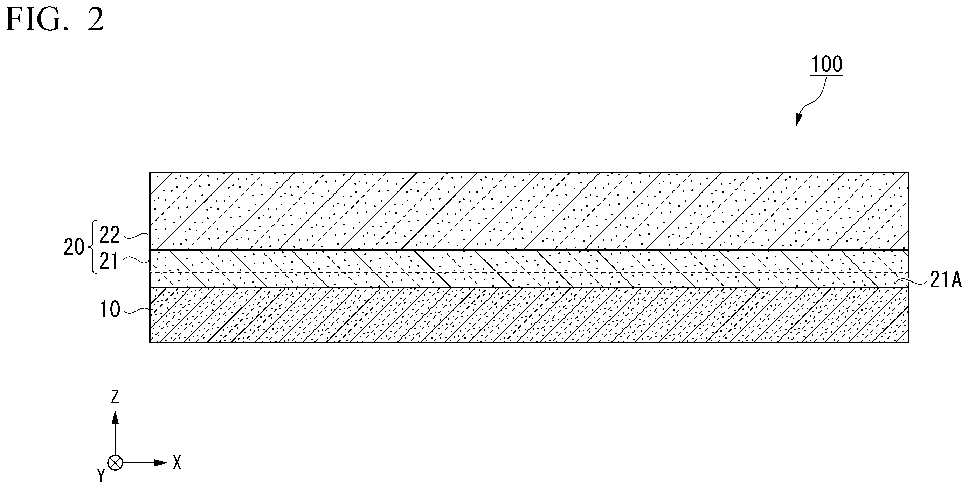

FIG. 2 is a cross-sectional view of the SiC epitaxial wafer 100 according to the first embodiment. The SiC epitaxial wafer 100 has a SiC substrate 10 and a SiC epitaxial layer 20.

The SiC substrate 10 is made of SiC. A crystal structure of SiC may be any one selected from 4H, 6H, 3C, and 15R. The SiC substrate 10 may be an n-type, a p-type, or a semi-insulating substrate. The SiC substrate 10 is, for example, an n-type SiC substrate doped with nitrogen as an impurity. The impurity concentration in the SiC substrate 10 is, for example, 1.0×10¹⁸ cm⁻³ or more and 2.0×10¹⁹ cm⁻³ or less. The impurities are, for example, nitrogen, phosphorus, aluminum, or boron.

The SiC substrate 10 may also be an offset substrate. The offset substrate is a substrate of which a crystal plane is inclined with respect to a surface of the SiC substrate 10. An angle between the crystal plane and the surface is called an offset angle. An offset θ of the offset substrate is, for example, 0.5° or more and 10° or less. The SiC substrate 10 may be a just substrate. The just substrate is a substrate of which a crystal plane is almost not inclined with respect to the surface of the SiC substrate 10. Therefore, an offset θ of the just substrate is, for example, 0° or more and 0.5° or less.

The SiC substrate 10 may have basal plane dislocations. The basal plane dislocations of the SiC substrate 10 are present along a (0001) plane (a c-plane). It is preferable that the number of basal plane dislocations exposed on a growth surface of the SiC substrate 10 is small. The basal plane dislocation density in the SiC substrate 10 is preferably 9000 dislocations/cm⁻² or less, more preferably 5000 dislocations/cm⁻² or less, even more preferably 2000 dislocations/cm⁻² or less, even more preferably 1000 dislocations/cm⁻² or less, and particularly preferably 500 dislocations/cm⁻² or less. Furthermore, the basal plane dislocation density in the SiC substrate 10 may be 0 dislocation/cm⁻² or greater than 0 dislocation/cm⁻².

The SiC epitaxial layer 20 is in contact with one surface of the SiC substrate 10. The SiC epitaxial layer 20 is laminated over the entire surface of the SiC substrate 10.

The SiC epitaxial layer 20 includes a buffer layer 21 and a drift layer 22. The buffer layer 21 is located between the drift layer 22 and the SiC substrate 10. The buffer layer 21 is formed on the SiC substrate 10, and the drift layer 22 is formed on the buffer layer 21.

The buffer layer 21 is a layer intended to convert basal plane dislocations present in the SiC substrate 10 into threading edge dislocations. In addition, the buffer layer 21 also has a function of preventing minority carriers from reaching the basal plane dislocations present in the SiC substrate 10 when a current is passed in the forward direction through a bipolar device having basal plane dislocations. The buffer layer 21 prevents Shockley type lamination defects from being formed in the SiC epitaxial layer 20 and from expanding.

The impurity concentration in the buffer layer 21 is higher than the impurity concentration in the drift layer 22. The impurity concentration in the buffer layer 21 is 2.0×10¹⁸ cm⁻³ or more. The impurity concentration in the buffer layer 21 is preferably 5.0×10¹⁸ cm⁻³ or more. For example, the impurity concentration in the buffer layer 21 is 2×10¹⁹ cm⁻³ or less. The impurity concentration in the buffer layer 21 is, for example, the average value of the average value of the impurity concentration in the Z direction at a center 1 and the average value of the impurity concentration in the Z direction at a first outer periphery point 2. The center 1 is a center when the epitaxial wafer 100 is seen in plan view in the Z direction. The first outer periphery point 2 is a position located 5 mm from the outermost periphery when the SiC epitaxial wafer 100 is seen in plan view. The first outer periphery point 2 is, for example, located at a position away from the center 1 in the X direction. The impurity concentration can be measured by secondary ion mass spectrometry (SIMS). The impurities are, for example, nitrogen, phosphorus, aluminum, and boron.

When the impurity concentration at the center 1 is measured in the laminating direction, uniformity of the impurity concentration in the buffer layer 21 is 50% or less. When the impurity concentration at the center 1 is measured in the laminating direction, the uniformity of the impurity concentration in the buffer layer 21 is preferably 45% or less, more preferably 30% or less, even more preferably 20% or less, and even more preferably 10% or less. Although not particularly limited, when the impurity concentration at the center 1 is measured in the laminating direction, the uniformity of the impurity concentration in the buffer layer 21 may be: 0.1% or more; 1% or more; 5% or more.

The uniformity of the impurity concentration in the buffer layer 21 is calculated by (Iₘₐₓ-Iₘᵢₙ)/Iₐᵥₑ.
Iₘₐₓ is the maximum value of the impurity concentration in the buffer layer 21 in the Z direction.
Iₘᵢₙ is the minimum value of the impurity concentration in the buffer layer 21 in the Z direction.
Iₐᵥₑ is the average value of the impurity concentration in the buffer layer 21 in the Z direction.

Moreover, the impurity concentration is likely to change near the interface between the SiC substrate 10 and the buffer layer 21. Hereinafter, a region within 3 µm toward the buffer layer 21 from the interface between the SiC substrate 10 and the buffer layer 21 is referred to as an interface vicinity region 21A. The interface vicinity region 21A is a region included in the buffer layer 21. When a thickness of the buffer layer 21 is less than 3 µm, the entire buffer layer 21A is the interface vicinity region 21A. When the impurity concentration at the center 1 is measured in the Z direction, a change range of the impurity concentration in the interface vicinity region 21A is preferably 50% or less of the average value of the impurity concentration in the buffer layer 21 in the Z direction, more preferably 45% or less, more preferably 35% or less, even more preferably 20% or less, and particularly preferably 10% or less. Although not particularly limited, when the impurity concentration at the center 1 is measured in the Z direction, a change range of the impurity concentration in the interface vicinity region 21A may be: 0.1% or more; 1% or more; 5% or more. The change range of the impurity concentration in the interface vicinity region 21A is the difference between the maximum value and the minimum value of the impurity concentration in the interface vicinity region 21A.

**In** addition, when the impurity concentration at the first outer periphery point 2 is measured in the Z direction, the uniformity of the impurity concentration in the buffer layer 21 is preferably 50% or less, more preferably 45% or less, more preferably 35% or less, still more preferably 25% or less, even more preferably 15% or less, and particularly preferably 10% or less. Although not particularly limited, when the impurity concentration at the first outer periphery point 2 is measured in the Z direction, the uniformity of the impurity concentration in the buffer layer 21 may be: 0.1% or more; 1% or more; 5% or more. Since a film formation gas spreads from the center 1 of the SiC substrate 10 toward the outer periphery, a variation in the impurity concentration in the Z direction at the first outer periphery point 2 is often smaller than a variation in the impurity concentration in the Z direction at the center 1. Furthermore, by implementing condition setting of the present application, the variation at the center 1 can be reduced, and a difference between the variation in the impurity concentration in the Z direction at the first outer periphery point 2 and the variation in the impurity concentration in the Z direction at the center 1 can be further reduced. The difference is preferably 18% or less, more preferably 10% or less, even more preferably 5% or less, and particularly preferably 1% or less.

When the impurity concentration at the first outer periphery point 2 is measured in the Z direction, the change range of the impurity concentration in the interface vicinity region 21A is preferably 50% or less of the average value of the impurity concentration in the buffer layer 21 in the Z direction, more preferably 45% or less, more preferably 35% or less, still more preferably 20% or less, even more preferably 15% or less, and particularly preferably 10% or less. Although not particularly limited, when the impurity concentration at the first outer periphery point 2 is measured in the Z direction, the change range of the impurity concentration in the interface vicinity region 21A may be: 0.1% or more of the average value of the impurity concentration in the buffer layer 21 in the Z direction; 1% or more; 5% or more.

In addition, when the impurity concentration at an arbitrary point when seen in plan view in the Z direction is measured in the Z direction, the uniformity of the impurity concentration in the buffer layer 21 is preferably 50% or less, more preferably 45% or less, even more preferably 40% or less, and further preferably 30% or less. Although not particularly limited, when the impurity concentration at an arbitrary point when seen in plan view in the Z direction is measured in the Z direction, the uniformity of the impurity concentration in the buffer layer 21 may be: 0.1% or more; 1% or more; 5% or more.

Furthermore, in-plane uniformity of the impurity concentration in the buffer layer 21 is preferably 50% or less, more preferably 30% or less, more preferably 25% or less, even more preferably 20% or less, and further preferably 10% or less. Although not particularly limited, in-plane uniformity of the impurity concentration in the buffer layer 21 may be: 0.1% or more; 1% or more; 5% or more.

The in-plane uniformity of the impurity concentration in the buffer layer 21 can be calculated by |(I₁-I₂)|/{(I₁+I₂)/2}. I₁ is the impurity concentration at the center 1, and I₂ is the impurity concentration at the first outer periphery point 2. That is, the in-plane uniformity of the impurity concentration in the buffer layer 21 is calculated by dividing an absolute value of the difference between the impurity concentration at the center 1 and the impurity concentration at the first outer periphery point 2 by a median of the impurity concentration at the center 1 and the impurity concentration at the first outer periphery point 2. Here, I₁ and I₂ are values measured at the same depth position in the Z direction in the buffer layer 21. For example, I₁ and I₂ are values measured at an interface between the buffer layer 21 and the drift layer 22 (that is, a surface of the buffer layer 21). Furthermore, I₁ and I₂ are preferably within 30% and more preferably within 20% of a median of I₁ and I₂.

The buffer layer 21 has a thickness of, for example, 0.1 µm or more, preferably 1 µm or more, and more preferably 3 µm or more. The buffer layer 21 has a thickness of, for example, 10 µm or less.

The drift layer 22 is a layer through which a drift current flows and in which elements such as transistors are formed when a SiC device is fabricated. The drift current is a current generated by a flow of carriers when a voltage is applied to a semiconductor.

The impurity concentration in the drift layer 22 is, for example, 1×10¹⁵ cm⁻³ or more. The impurity concentration in the drift layer 22 is, for example, 1×10¹⁸ cm⁻³ or less. The thickness of the drift layer 22 is, for example, 5 µm or more. The impurity concentration in the drift layer 22 is the average value of the average value of the impurity concentration in the Z direction at the center 1 and the average value of the impurity concentration in the Z direction at the first outer periphery point 2.

The basal plane dislocation density in the drift layer 22 is, for example, 0.25 dislocations/cm⁻² or less. The basal plane dislocation density in drift layer 22 is preferably 0.10 dislocations/cm⁻² or less, more preferably 0.05 dislocations/cm⁻² or less, even more preferably 0.03 dislocations/cm⁻² or less, particularly preferably 0.01 dislocations/cm⁻² or less, and most preferably 0 dislocation/cm⁻². The basal plane dislocation density in the drift layer 22 may be measured at a surface of the drift layer 22.

Many of the basal plane dislocations in the SiC substrate 10 are converted into threading edge dislocations in the buffer layer 21. The basal plane dislocations are converted into threading edge dislocations at the interface between SiC substrate 10 and buffer layer 21, midway through buffer layer 21, and at the interface between buffer layer 21 and drift layer 22. A conversion rate of the basal plane dislocations in the buffer layer 21 is, for example, preferably 99.997% or more, more preferably 99.999% or more, and most preferably 100%. The conversion rate of the basal plane dislocations in buffer layer 21 can be calculated by dividing the basal plane dislocation density in drift layer 22 by the basal plane dislocation density in the SiC substrate and subtracting a result thereof from one. A high conversion rate of the basal plane dislocations to the threading edge dislocations in the buffer layer 21 can be achieved by growing the SiC epitaxial layer at a high rate.

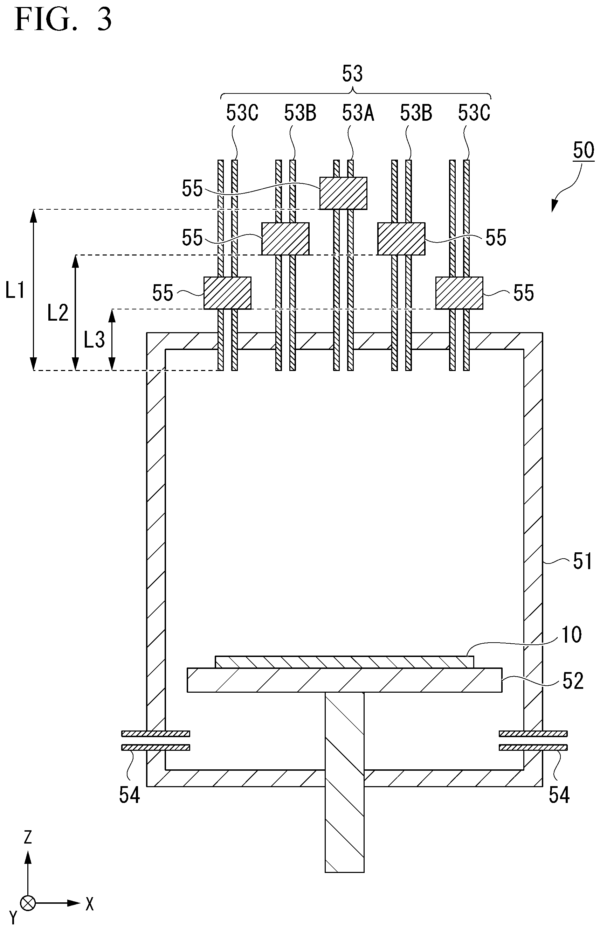

Next, a description will be given of a method for manufacturing the SiC epitaxial wafer 100 according to the embodiment. FIG. 3 is a cross-sectional view of an apparatus 50 for manufacturing the SiC epitaxial wafer 100 according to the embodiment.

The manufacturing apparatus 50 includes a housing 51, a support 52, a gas introduction part 53, a gas discharge part 54, and a mass flow controller 55. The housing 51 encloses a film formation space. The SiC substrate 10 is placed on the support 52 during film formation.

The gas introduction part 53 is a supply port for a film formation gas. The film formation gas is a Si-based gas, a C-based gas, a dopant gas, a carrier gas, or the like. The Si-based gas is a source gas containing Si in a molecule thereof. Examples of the Si-based gas include silane (SiH₄), dichlorosilane (SiH₂Cl₂), trichlorosilane (SiHCl₃), tetrachlorosilane (SiCl₄), and the like. The C-based gas is, for example, propane (C₃H₈), ethylene (C₂H₄), or the like. The dopant gas is a gas containing an element that serves as a carrier. The dopant gas is, for example, nitrogen. A purge gas is a gas that carries these gases to the SiC substrate 10, and is, for example, hydrogen that is inactive with respect to SiC.

The gas introduction part 53 has, for example, an inner peripheral gas supply port 53A, an intermediate gas supply port 53B, and an outer peripheral gas supply port 53C. The inner peripheral gas supply port 53A is a gas supply port located radially innermost when seen in the Z direction. The outer peripheral gas supply port 53C is a gas supply port located radially outermost when seen in the Z direction. The intermediate gas supply port 53B is a gas supply port located between the inner peripheral gas supply port 53A and the outer peripheral gas supply port 53C in the radial direction when seen in the Z direction. Gas supply amounts from the inner peripheral gas supply port 53A, the intermediate gas supply port 53B, and the outer peripheral gas supply port 53C are individually controlled by the mass flow controller 55. The types of gas supplied from the inner peripheral gas supply port 53A, the intermediate gas supply port 53B, and the outer peripheral gas supply port 53C may be the same or different. For example, the C-based gas is supplied from the inner peripheral gas supply port 53A and the outer peripheral gas supply port 53C, and the Si-based gas is supplied from the intermediate gas supply port 53B.

The gas discharge part 54 is located below the surface of the support 52 on which the SiC substrate 10 is placed. The gas discharge part 54 is located on the side wall of the housing 51, for example. The film formation gas supplied from the gas introduction part 53 is recrystallized on the surface of the SiC substrate 10, and the remaining gas is discharged from the gas discharge part 54.

The outer peripheral gas supply port 53C is closer to the gas discharge part 54 than the inner peripheral gas supply port 53A and the intermediate gas supply port 53B, and is therefore more susceptible to an influence of the gas discharged from the gas discharge part 54. The gas supplied from a first end of the inner peripheral gas supply port 53A flows straight toward the SiC substrate 10, whereas the gas supplied from a first end of the outer peripheral gas supply port 53 flows while spreading outward. Therefore, a length of a flow path through which a gas flows from the first end of the inner peripheral gas supply port 53A to the SiC substrate 10 is shorter than a length of a flow path through which a gas flows from the first end of the outer peripheral gas supply port 53C to the SiC substrate 10. The first end is an end portion of the gas supply port on the side of the film formation space.

In order to reduce a difference in length of the gas flow path in the film formation space, a distance between the mass flow controller 55 and the first end of each of the inner peripheral gas supply port 53A, the intermediate gas supply port 53B, and the outer peripheral gas supply port 53C is changed. A distance L1 between the mass flow controller 55 and the first end at the inner peripheral gas supply port 53A is longer than, for example, a distance L2 between the mass flow controller 55 and the first end at the intermediate gas supply port 53B and a distance L3 between the mass flow controller 55 and the first end at the outer peripheral gas supply port 53C. Further, the distance L2 between the mass flow controller 55 and the first end at the intermediate gas supply port 53B is longer than the distance L3 between the mass flow controller 55 and the first end at the outer peripheral gas supply port 53C.

The specific lengths of the distances L1, L2, and L3 are adjusted by setting conditions as described below. A gas supply state on the surface of SiC substrate 10 varies according to the distances L1, L2, and L3, and an effective C/Si ratio on the surface of SiC substrate 10 can be changed by changing the distances L1, L2, and L3. The effective C/Si ratio is a ratio of the C-based gas to the Si-based gas in the vicinity of a film being formed.

Next, condition setting is performed to determine the specific lengths of the distances L1, L2, and L3. First, the SiC substrate 10 for condition setting is placed on the support 52. The SiC substrate 10 for condition setting is preferably the same as the SiC substrate 10 used in the actual film formation. For example, a substrate having a basal plane dislocation density of 9000 dislocations/cm⁻² or less is used as the SiC substrate 10.

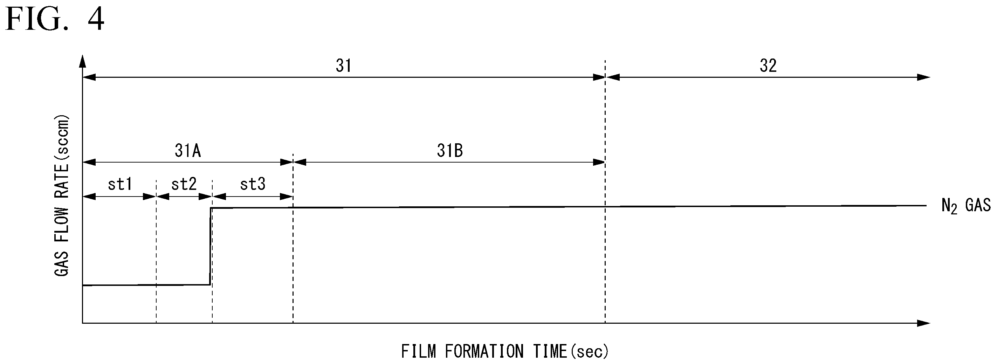

FIG. 4 shows various conditions for forming the SiC epitaxial layer 20. When the SiC epitaxial layer 20 is grown, there is a first period 31 in which the buffer layer 21 is grown in crystal, and a second period 32 in which the drift layer 22 is grown in crystal. In the condition setting, the film formation in the first period 31 (that is, the formation of the buffer layer 21) is performed a plurality of times to set the distances L1, L2, and L3. The film formation conditions in the first period 31 in the condition setting are set to be the same as the actual film formation conditions.

The first period 31 is divided into an initial crystal growth period 31A and a steady crystal growth period 31B. The initial crystal growth period 31A is a period until the flow rates of the Si-based gas and the C-based gas during crystal growth become constant. The steady crystal growth period 31B is a period after the flow rates of the Si-based gas and the C-based gas become constant.

In the initial crystal growth period 31A, the flow rates of the Si-based gas and the C-based gas are gradually ramped up. The flow rate of the nitrogen gas is kept constant in each of three steps into which the initial crystal growth period 31A is divided.

Hereinafter, the first step in the initial crystal growth period 31A is referred to as a first step St1, the next step is referred to as a second step St2, and the last step is referred to as a third step St3. For example, the initial crystal growth period 31A may be equally divided into the first step St1, the second step St2, and the third step St3. Also, the initial crystal growth period 31A may be divided at different ratios to form the first step St1, the second step St2, and the third step St3.

A supply amount of the nitrogen gas in each of the first step St1, the second step St2, and the third step St3 may be the same or different. For example, the supply amount of the nitrogen gas in the first step St1 may be 100 sccm, the supply amount of the nitrogen gas in the second step St2 may be 200 sccm, and the supply amount of the nitrogen gas in the third step St3 may be 300 sccm. Furthermore, the supply amount of the nitrogen gas in the earlier step may be less than or greater than the supply amount of the nitrogen gas in the later step. For example, the nitrogen gas may be supplied at a maximum flow rate in the first step St1, and the supply amount of the nitrogen gas may be decreased as the process proceeds to the second step St2 and the third step St3. For example, the supply amount of the nitrogen gas in the first step St1 may be 300 sccm, the supply amount of the nitrogen gas in the second step St2 may be 200 sccm, and the supply amount of the nitrogen gas in the third step St3 may be 100 sccm.

**In** each of the first step St1, the second step St2, and the third step St3, the C/Si ratio is constant. The ease with which impurities (for example, nitrogen) are incorporated into the SiC epitaxial layer 20 during crystal growth varies according to the C/Si ratio. The supply amounts of the C-based gas and the Si-based gas are adjusted according to the supply amount of the nitrogen gas in each of the first step St1, the second step St2, and the third step St3.

The C/Si ratio in each of the first step St1, the second step St2, and the third step St3 may be the same or different. A rate at which the flow rates of the Si-based gas and the C-based gas are ramped up (a gradient of a change in the gas flow rate over time) may be changed in each of the first step St1, the second step St2, and the third step St3.

Although the example in which the initial crystal growth period 31A is divided into three steps has been described, the number of divisions in the initial crystal growth period 31A may be four or more steps. The number of divisions in the initial crystal growth period 31A is preferably eight steps or less.

The distances L1, L2, and L3 are set while the uniformity of the impurity concentration in the laminating direction at the center 1 of the SiC substrate 10 for each of the film formation steps in the initial crystal growth period 31A is checked.

First, the distance L1 is set because the film formation gas spreads from the inside to the outside in the radial direction of the film formation apparatus 50. The initial setting of the distance L1 is, for example, 100 mm. Under these conditions, the film formation in the first step St1 is performed, and the uniformity of the impurity concentration in the laminating direction at the center 1 of the SiC substrate 10 is measured. When the uniformity of the impurity concentration in the laminating direction at the center 1 of SiC substrate 10 exceeds 50%, the distance L1 is changed. When the uniformity of the impurity concentration in the laminating direction at the center 1 of SiC substrate 10 is 50% or less, the distance L1 is provisionally set. When the uniformity of the impurity concentration in the laminating direction at the center 1 of the SiC substrate 10 exceeds 50%, the film formation in the first step St1, the measuring of the uniformity of the impurity concentration in the laminating direction at the center 1 of the SiC substrate 10, and the changing of the distance L1 are repeated. Then, when the uniformity of the impurity concentration in the laminating direction at the center 1 of SiC substrate 10 becomes 50% or less, the distance L1 is provisionally set.

After the distance L1 is provisionally set, the distance L2 is set. Similar to the provisional setting of the distance L1, the distance L2 is determined by repeatedly performing the film formation in the first step St1, the measuring of the uniformity of the impurity concentration in the laminating direction at the center 1 of SiC substrate 10, and the changing of the distance L1. When the uniformity of the impurity concentration in the laminating direction at the center 1 of SiC substrate 10 becomes 50% or less, the distance L2 is provisionally set.

After the distance L2 is provisionally set, the distance L3 is set. Similarly to the provisional setting of the distance L1, the distance L3 is determined by repeatedly performing the film formation in the first step St1, the measuring of the uniformity of the impurity concentration in the laminating direction at the center 1 of SiC substrate 10, and the changing of the distance L1. When the uniformity of the impurity concentration in the laminating direction at the center 1 of SiC substrate 10 becomes 50% or less, the distance L3 is provisionally set.

Next, the film formation is performed in the first step St1 at the provisionally set distances L1, L2, and L3, and the uniformity of the impurity concentration in the laminating direction at the first outer periphery point 2 of the SiC substrate 10 is measured. When the uniformity of the impurity concentration in the laminating direction at the first outer periphery point 2 of the SiC substrate 10 exceeds 50%, the provisionally set distances L1, L2, and L3 are adjusted. The adjustment of the distance L1, the distance L2, and the distance L3 is performed in the order of the distance L1, the distance L2, and the distance L3.

The same processes as those for the distances L1, L2, and L3 in the first step St1 described above is performed in each of the second step St2 and the third step St3. Finally, in each of the first step St1, the second step St2 and the third step St3, the distances L1, L2 and L3 are set so that the uniformity of the impurity concentration in the laminating direction at the center 1 and the first outer periphery point 2 is 50% or less.

After the distances L1, L2, and L3 are set, confirmation film formation is performed under those conditions. During the confirmation film formation, the flow rate of the gas is adjusted to adjust an in-plane distribution of the gas in an in-plane direction of the SiC substrate 10. **In** the confirmation film formation, it is confirmed again that the uniformity of the impurity concentration in the laminating direction at the center 1 and the first outer periphery point 2 is 50% or less.

The distances L1, L2, and L3 and the gas flow rates are set for each apparatus. This is because there are variations between the apparatuses. Furthermore, when the film formation apparatus 50 is cleaned, the conditions may change, and thus such condition setting is preferably performed.

After the various conditions are determined by the above procedure, a main film formation is performed. In the main film formation, the buffer layer 21 is formed in the first period 31 and the drift layer 22 is formed in the second period 32 under the set conditions. The growth rate of the SiC epitaxial layer 20 in the initial crystal growth period 31A is set to 5 µm/h or more and 80 µm/h or less. The growth rate of the SiC epitaxial layer 20 in the steady crystal growth period 31B is set to 50 µm/h or more. In the second period 32, the C/Si ratio is set to be higher than that in the first period 31, for example.

During the initial crystal growth period 31A, the crystal growth may become unstable, and an amount of incorporated impurities may be varied. By precisely controlling the crystal growth conditions in the initial crystal growth period 31A, it is possible to curb large change in the amount of incorporated impurity concentration during the initial crystal growth period 31A, and to manufacture the SiC epitaxial wafer 100 according to the embodiment.

As described above, in the SiC epitaxial wafer 100 according to the embodiment, the change in the impurity concentration in the buffer layer 21 in the Z direction is small. Furthermore, in the SiC epitaxial wafer 100 according to the embodiment, the conversion rate of the basal plane dislocations to the threading edge dislocations in the buffer layer 21 is high. In other words, the SiC epitaxial wafer 100 according to the embodiment can curb the change in the impurity concentration in the Z direction, and has a high conversion rate of the basal plane dislocations to the threading edge dislocations. Therefore, high-quality SiC devices can be manufactured using the SiC epitaxial wafer 100 according to the embodiment.

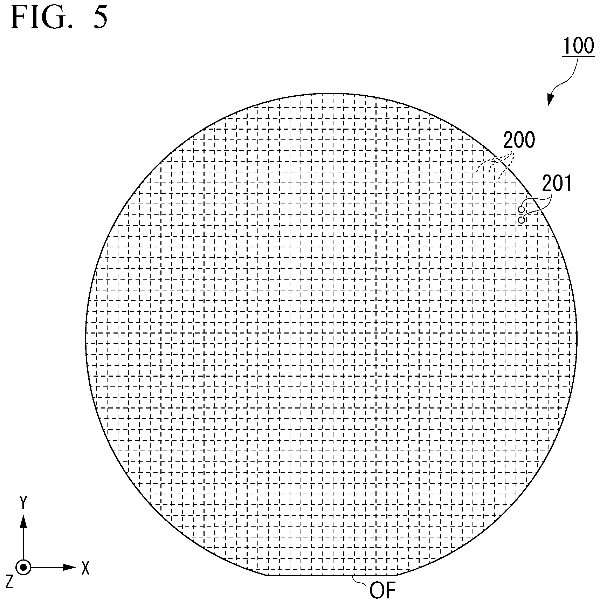

A SiC device can be obtained from the SiC epitaxial wafer 100 according to the embodiment. FIG. 5 is a plan view showing a SiC device 200 according to the first embodiment. The SiC device 200 can be manufactured by forming devices such as transistors on the SiC epitaxial wafer 100 and forming the devices into chips. In FIG. 5, the SiC epitaxial wafer 100 is divided into rectangular sections each of which is a SiC device. The SiC device 200 may be manufactured by forming devices such as transistors on the SiC epitaxial wafer 100 after dividing the SiC epitaxial wafer 100 into chips.

The SiC device 200 according to the embodiment includes a chipped SiC substrate and a SiC epitaxial layer on one surface of the chipped SiC substrate. Devices such as transistors are formed in the drift layer of the SiC epitaxial layer. The impurity concentrations and basal plane dislocation densities of the SiC substrate, the buffer layer, and the drift layer in the SiC device 200 are similar to those of the SiC epitaxial wafer 100 before being formed into chips.

For example, when the impurity concentration in the SiC device 200 is measured in the Z direction, the uniformity of the impurity concentration in the buffer layer is 50% or less, preferably 45% or less, more preferably 30% or less, more preferably 20% or less, more preferably 15% or less, and even more preferably 10% or less. The impurity concentration in the SiC devices 200 is measured, for example, at the center 201 of each of the SiC devices 200. The impurity concentration in SiC device 200 is the average value in the Z direction at the center 201.

For example, when the impurity concentration at the center 201 of the SiC device 200 is measured in the Z direction, the change range in the impurity concentration in the interface vicinity region is preferably 50% or less of the average value of the impurity concentration in the buffer layer in the Z direction, more preferably 45% or less, still more preferably 35% or less, even more preferably 20% or less, and particularly preferably 10% or less.

Furthermore, for example, the impurity concentration in the drift layer in SiC device 200 may be 1.0×10¹⁵ cm⁻³ or more and 1.0x10¹⁸ cm⁻³ or less. Also, for example, the basal plane dislocation density in the drift layer of the SiC device 200 may be 0.25 dislocations/cm⁻² or less. The impurity concentration of the buffer layer in the SiC device 200 is 2.0×10¹⁸ cm⁻³ or more. For example, the impurity concentration of the buffer layer in the SiC device 200 may be 1.0×10¹⁹ cm⁻³ or less. Also, for example, the conversion rate of the basal plane dislocations in the buffer layer of SiC device 200 may be 99.997% or more. For example, the basal plane dislocation density in the SiC substrate may be 9000 dislocations/cm⁻² or less.

Although the preferred embodiment of the present invention has been described in detail above, the present invention is not limited to the specific embodiment, and various modifications and changes are possible within the scope of the gist of the present invention described in the claims.

### [Examples]

### [Example 1]

A SiC substrate 10 having a diameter of 150 mm (6 inches) and an offset angle of 4° was prepared. The basal plane dislocation density of the SiC substrate 10 was 9000 dislocations/cm⁻². The nitrogen concentration of the SiC substrate 10 was 6.0×10¹⁸ cm⁻².

Next, the buffer layer 21 and the drift layer 22 were laminated in this order on the SiC substrate 10. When the buffer layer 21 was formed, the initial crystal growth period 31A was divided into three steps. The supply amount of the nitrogen gas was kept constant in each of the three divided steps. The C-based gas and the Si-based gas were gradually ramped up in the initial crystal growth period 31A.

**In** addition, when the SiC epitaxial layer 20 is formed, the gas supply port is divided into an inner peripheral gas supply port, an intermediate gas supply port, and an outer peripheral gas supply port, and the amount of gas supplied from each of the ports is controlled individually. The distance between the mass flow controller and each of the inner peripheral gas supply port, the intermediate gas supply port and the outer peripheral gas supply port, and the gas supply amount from each of the inner peripheral gas supply port, the intermediate gas supply port and the outer peripheral gas supply port were determined in advance. The growth rate of the SiC epitaxial layer 20 during film formation was set to be in a range of 5 µm/h to 80 µm/h in the initial crystal growth period 31A, and 50 µm/h or higher in the steady crystal growth period 31B.

The nitrogen concentrations in the Z direction at the center 1 and the first outer periphery point 2 of the manufactured SiC epitaxial layer 20 were measured using SIMS.

The maximum value Iₘₐₓ of the impurity concentration of the buffer layer 21 at the center 1 was 6.0×10¹⁸ cm⁻³. The minimum value Iₘᵢₙ of the impurity concentration of the buffer layer 21 at the center 1 was 3.4×10¹⁸ cm⁻³. The average value Iₐᵥₑ of the impurity concentration of the buffer layer 21 at the center 1 was 5.3×10¹⁸ cm⁻³. The uniformity of the impurity concentration of the buffer layer 21 at the center 1 was 49% and was 50% or less.

The maximum value Iₘₐₓ of the impurity concentration of the buffer layer 21 at the first outer periphery point 2 was 5.0×10¹⁸ cm⁻³. The minimum value Iₘᵢₙ of the impurity concentration of the buffer layer 21 at the first outer periphery point 2 was 3.5×10¹⁸ cm⁻³. The average value Iₐᵥₑ of the impurity concentration of the buffer layer 21 at the first outer periphery point 2 was 4.7×10¹⁸ cm⁻³. The uniformity of the impurity concentration of the buffer layer 21 at the first outer periphery point 2 was 32% and was 35% or less.

The average impurity concentration of the buffer layer 21 in Example 1 is 5.0×10¹⁸ cm⁻³. The average impurity concentration of the buffer layer 21 is calculated by adding the average value Iₐᵥₑ of the impurity concentration of the buffer layer 21 at the center 1 and the average value Iₐᵥₑ of the impurity concentration of the buffer layer 21 at the first outer periphery point 2 and dividing the sum by 2.

The basal plane dislocation density in the surface of the SiC epitaxial layer 20 manufactured under the same conditions was also measured. That is, the basal plane dislocation density in the drift layer 22 was 0.24 dislocations/cm⁻². The conversion rate of the basal plane dislocations in buffer layer 21, which was calculated by dividing the basal plane dislocation density in drift layer 22 by the basal plane dislocation density of SiC substrate 10 and multiplying the result by 100, was 99.997%. The in-plane uniformity of the impurity concentration in the buffer layer 21 was 18%. The in-plane uniformity was measured at the interface between the buffer layer 21 and the drift layer 22.

### [Example 2]

Example 2 differs from Example 1 in that the SiC substrate was changed to one having a diameter of 200 mm (8 inches) and an offset angle of 4°. The other conditions were the same as in Example 1, and measurements similar to those in Example 1 were performed.

In Example 2, the maximum value Iₘₐₓ of the impurity concentration of the buffer layer 21 at the center 1 was 5.7×10¹⁸ cm⁻³. The minimum value Iₘᵢₙ of the impurity concentration of the buffer layer 21 at the center 1 was 3.5×10¹⁸ cm⁻³. The average value Iₐᵥₑ of the impurity concentration of the buffer layer 21 at the center 1 was 5.1×10¹⁸ cm⁻³. The uniformity of the impurity concentration of the buffer layer 21 at the center 1 was 43%.

In Example 2, the maximum value Iₘₐₓ of the impurity concentration of the buffer layer 21 at the first outer periphery point 2 was 4.5×10¹⁸ cm⁻³. The minimum value Iₘᵢₙ of the impurity concentration of the buffer layer 21 at the first outer periphery point 2 was 2.7×10¹⁸ cm⁻³. The average value Iₐᵥₑ of the impurity concentration of the buffer layer 21 at the first outer periphery point 2 was 4.1×10¹⁸ cm⁻³. The uniformity of the impurity concentration of the buffer layer 21 at the first outer periphery point 2 was 44%.

The average impurity concentration of the buffer layer 21 in Example 2 is 4.6×10¹⁸ cm⁻³.

The basal plane dislocation density in the surface of the SiC epitaxial layer 20 manufactured under the same conditions was also measured. That is, the basal plane dislocation density in the drift layer 22 was 0.24 dislocations/cm⁻². The conversion rate of the basal plane dislocations in the buffer layer 21, which is calculated by dividing the basal plane dislocation density in the drift layer 22 by the basal plane dislocation density in SiC substrate 10 and multiplying the result by 100, was 99.997%. The in-plane uniformity of the impurity concentration of the buffer layer 21 was 22%.

### [Comparative example 1]

In Comparative example 1, the initial crystal growth period 31A was not particularly divided and controlled, and the supply amount of the nitrogen gas was ramped up during the initial crystal growth period 31A. In addition, in Comparative example 1, the gas supply port was not divided into the inner peripheral gas supply port, the intermediate gas supply port, and the outer peripheral gas supply port, and the distance between the mass flow controller and each of the inner peripheral gas supply port, the intermediate gas supply port, and the outer peripheral gas supply port was not adjusted. In Comparative Example 1, the gas supply amounts from the respective gas supply ports were controlled collectively. The other conditions were the same as those in Example 1.

The nitrogen concentrations in the Z direction at the center 1 and the first outer periphery point 2 of the SiC epitaxial layer of Comparative example 1 were measured using SIMS.

The maximum value Iₘₐₓ of the impurity concentration of the buffer layer at the center 1 of Comparative Example 1 was 6.0×10¹⁸ cm⁻³. The minimum value Iₘᵢₙ of the impurity concentration of the buffer layer at the center 1 of Comparative Example 1 was 1.5×10¹⁸ cm⁻³. The average value Iₐᵥₑ of the impurity concentration of the buffer layer at the center 1 of Comparative example 1 was 5.1×10¹⁸ cm⁻³. The uniformity of the impurity concentration of the buffer layer at the center 1 of Comparative example 1 was 88% and was 90% or less.

The maximum value Iₘₐₓ of the impurity concentration of the buffer layer at the first outer periphery point 2 in Comparative Example 1 was 4.0×10¹⁸ cm⁻³. The minimum value Iₘᵢₙ of the impurity concentration of the buffer layer 21 at the first outer periphery point 2 in Comparative Example 1 was 1.5×10¹⁸ cm⁻³. The average value Iₐᵥₑ of the impurity concentration of the buffer layer 21 at the first outer periphery point 2 in Comparative example 1 was 3.6×10¹⁸ cm⁻³. The uniformity of the impurity concentration of the buffer layer 21 at the first outer periphery point 2 in Comparative example 1 was 69% and was 70% or less.

The average impurity concentration of the buffer layer 21 in Comparative example 1 is 4.4×10¹⁸ cm⁻³.

The basal plane dislocation density in the surface of the SiC epitaxial layer manufactured under the same conditions was also measured. That is, the basal plane dislocation density in the drift layer of Comparative example 1 was 0.24 dislocations/cm⁻². The conversion rate of the basal plane dislocations in Comparative example 1 was 99.997%. The in-plane uniformity of the impurity concentration in the buffer layer in Comparative example 1 was 40%.

### [Reference example 1]

Reference example 1 differs from Comparative Example 1 in that the impurity concentration of the buffer layer 21 was changed. Furthermore, in Reference Example 1, the nitrogen concentration of the SiC substrate 10 was set to 1.0×10¹⁸ cm⁻². Other conditions were the same as those of Comparative example 1.

The nitrogen concentrations in the Z direction at the center 1 and the first outer periphery point 2 of the SiC epitaxial layer of Reference example 1 were measured using SIMS.

The maximum value Iₘₐₓ of the impurity concentration of the buffer layer at the center 1 of Reference example 1 was 7.0×10¹⁷ cm⁻³. The minimum value Iₘᵢₙ of the impurity concentration of the buffer layer at the center 1 of Reference example 1 was 4.5×10¹⁷ cm⁻³. The average value Iₐᵥₑ of the impurity concentration of the buffer layer at the center 1 of Reference example 1 was 5.5×10¹⁷ cm⁻³. The uniformity of the impurity concentration of the buffer layer at the center 1 of Reference example 1 was 45%.

The maximum value Iₘₐₓ of the impurity concentration of the buffer layer at the first outer periphery point 2 in Reference example 1 was 1.2×10¹³ cm⁻³. The minimum value Iₘᵢₙ of the impurity concentration of the buffer layer 21 at the first outer periphery point 2 in Reference example 1 was 7.0×10¹⁷ cm⁻³. The average value Iₐᵥₑ of the impurity concentration of the buffer layer 21 at the first outer periphery point 2 in Reference example 1 was 1.0×10¹⁵ cm⁻³. The uniformity of the impurity concentration of the buffer layer 21 at the first outer periphery point 2 in Reference example 1 was 50%.

The average impurity concentration of the buffer layer 21 in Reference example 1 is 7.75×10¹⁷ cm⁻³.

The basal plane dislocation density in the surface of the SiC epitaxial layer fabricated under the same conditions was also measured. That is, the basal plane dislocation density in the drift layer of Reference example 1 was 0.24 dislocations/cm⁻². The conversion rate of the basal plane dislocations in Reference example 1 was 99.997%. The in-plane uniformity of the impurity concentration in the buffer layer in Reference example 1 was 58%.

In Reference Example 1, the average impurity concentration of the buffer layer 21 is less than 2.0×10¹⁸ cm⁻³, and the change in the impurity concentration in the Z direction is small even without any special manufacturing method. From this result, it can be confirmed that when the average impurity concentration of the buffer layer 21 is 2.0×10¹⁸ cm⁻³ or more, the change in the impurity concentration in the Z direction becomes large.

### EXPLANATION OF REFERENCES

10 SiC substrate
20 SiC epitaxial layer
21 Buffer layer
21A Interface vicinity region
22 Drift layer
100 SiC epitaxial wafer
31 First period
31A Initial crystal growth period
31B Steady crystal growth period
St1 First step
St2 Second step
St3 Third step
200 SiC device
201 Center

## Claims

1. A SiC epitaxial wafer comprising:
a SiC substrate; and
a SiC epitaxial layer on one surface of the SiC substrate,
wherein the SiC epitaxial layer has a buffer layer and a drift layer,
the buffer layer is located between the drift layer and the SiC substrate, and has an impurity concentration higher than an impurity concentration of the drift layer,
an impurity concentration of the buffer layer is 2.0×10¹⁸ cm⁻³ or more,
in a case where the impurity concentration at a center in plan view in a laminating direction is measured in the laminating direction, uniformity of the impurity concentration in the buffer layer is 50% or less,
the uniformity of the impurity concentration in the buffer layer is calculated by (Iₘₐₓ-Iₘᵢₙ)/Iₐᵥₑ,
Iₘₐₓ is a maximum value of the impurity concentration in the buffer layer in the laminating direction,
Iₘᵢₙ is a minimum value of the impurity concentration in the buffer layer in the laminating direction, and
Iₐᵥₑ is an average value of the impurity concentration in the buffer layer in the laminating direction.

2. The SiC epitaxial wafer according to claim 1, wherein, in a case where the impurity concentration at a first outer periphery point located 5 mm from an outermost periphery in plan view in the laminating direction is measured in the laminating direction, the uniformity of the impurity concentration in the buffer layer is 50% or less.

3. The SiC epitaxial wafer according to claim 1 or 2, wherein, in a case where the impurity concentration at any point in plan view in the laminating direction is measured in the laminating direction, the uniformity of the impurity concentration in the buffer layer is 50% or less.

4. The SiC epitaxial wafer according to any one of claims 1 to 3, wherein, in a case where the impurity concentration at the center in plan view in the laminating direction is measured in the laminating direction, in an interface vicinity region within 3 µm toward the buffer layer from an interface between the SiC substrate and the buffer layer, a change range of the impurity concentration is 50% or less of the average value of the impurity concentration in the buffer layer in the laminating direction.

5. The SiC epitaxial wafer according to any one of claims 1 to 4, wherein, in a case where an impurity concentration at a first outer periphery point located 5 mm from an outermost periphery in plan view in the laminating direction is measured in the laminating direction, in an interface vicinity region within 3 µm toward the buffer layer from an interface between the SiC substrate and the buffer layer, a change range of the impurity concentration is 50% or less of the average value of the impurity concentration in the buffer layer in the laminating direction.

6. The SiC epitaxial wafer according to any one of claims 1 to 5, wherein an in-plane uniformity of the impurity concentration in the buffer layer is 50% or less,
the in-plane uniformity of the impurity concentration in the buffer layer is calculated by |I₁-I₂|/{(I₁+I₂)/2},
I₁ is the impurity concentration of the buffer layer at the center in plan view in the laminating direction,
I₂ is the impurity concentration of the buffer layer at a first outer periphery point located 5 mm from an outermost periphery in plan view in the laminating direction.

7. The SiC epitaxial wafer according to any one of claims 1 to 6, wherein an impurity concentration of the drift layer is 1.0×10¹⁵ cm⁻³ or more and 1.0×10¹⁸ cm⁻³ or less.

8. The SiC epitaxial wafer according to any one of claims 1 to 7, wherein a conversion rate of basal plane dislocations in the buffer layer is 99.997% or more.

9. The SiC epitaxial wafer according to any one of claims 1 to 8, wherein a basal plane dislocation density in the drift layer is 0.25 dislocations/cm⁻² or less.

10. The SiC epitaxial wafer according to any one of claims 1 to 9, wherein a diameter is 149 mm or more.

11. The SiC epitaxial wafer according to any one of claims 1 to 10, wherein a diameter is 199 mm or more.

12. A SiC device comprising:
a SiC substrate; and
a SiC epitaxial layer on one surface of the SiC substrate,
wherein the SiC epitaxial layer has a buffer layer and a drift layer,
the buffer layer is located between the drift layer and the SiC substrate, and has an impurity concentration higher than an impurity concentration of the drift layer,
an impurity concentration of the buffer layer is 2.0×10¹⁸ cm⁻³ or more,
in a case where the impurity concentration is measured in a laminating direction, uniformity of the impurity concentration in the buffer layer is 50% or less,
the uniformity of the impurity concentration in the buffer layer is calculated by (Iₘₐₓ-Iₘᵢₙ)/Iₐᵥₑ,
Iₘₐₓ is a maximum value of the impurity concentration in the buffer layer in the laminating direction,
Iₘᵢₙ is a minimum value of the impurity concentration in the buffer layer in the laminating direction, and
Iₐᵥₑ is an average value of the impurity concentration in the buffer layer in the laminating direction.

13. The SiC device according to claim 12, wherein, in a case where the impurity concentration at a center in plan view in the laminating direction is measured in the laminating direction, in an interface vicinity region within 3 µm toward the buffer layer from an interface between the SiC substrate and the buffer layer, a change range of the impurity concentration is 50% or less of the average value of the impurity concentration in the buffer layer in the laminating direction.

14. The SiC device according to claim 12 or 13, wherein an impurity concentration of the drift layer is 1.0×10¹⁵ cm⁻³ or more and 1.0×10¹⁸ cm⁻³ or less.

15. The SiC device according to any one of claims 12 to 14, wherein a conversion rate of basal plane dislocations in the buffer layer is 99.997% or more.
